# EUROPÄISCHE PATENTSCHRIFT

(11) **EP 2 097 904 B1**
(45) Veröffentlichungstag und Bekanntmachung des Hinweises auf die Patenterteilung: **15.06.2011**
(21) Anmeldenummer: 07846385.8
(22) Anmeldetag: 03.12.2007
(51) Int. Cl.: G11C 16/02, H01L 29/788

(54) **SPEICHERZELLE UND VERFAHREN ZUM SPEICHERN VON DATEN**
MEMORY CELL, AND METHOD FOR STORING DATA
CELLULE DE MÉMOIRE ET PROCÉDÉ DE STOCKAGE DE DONNÉES

(30) Priorität: 08.12.2006 DE 102006059110
(43) Veröffentlichungstag der Anmeldung: 09.09.2009
(73) Patentinhaber: Technische Universität Berlin, 10623 Berlin (DE)
(72) Erfinder: BIMBERG, Dieter, 14089 Berlin (DE); GELLER, Martin, 10551 Berlin (DE); MARENT, Andreas, 10551 Berlin (DE)
(74) Vertreter: Fischer, Uwe
(86) Internationale Anmeldenummer: PCT/DE2007/002182
(87) Internationale Veröffentlichungsnummer: WO 2008/067799

(56) Entgegenhaltungen:
- GB-A- 2 341 722
- KOIKE K ET AL: "Charge storage effect of the vertically stacked InAs nanodots embedded in Al0.5Ga0.5As matrix" CONFERENCE PROCEEDINGS. 2001 INTERNATIONAL CONFERENCE ON INDIUM PHOSPHIDE AND RELATED MATERIALS. IPRM. NARA, JAPAN, MAY 14 - 18, 2001; [INTERNATIONAL CONFERENCE ON INDIUM PHOSPHIDE AND RELATED MATERIALS], NEW YORK, NY : IEEE, US, Bd. CONF. 13, 14. Mai 2001 (2001-05-14), Seiten 39-42, XP010546968 ISBN: 978-0-7803-6700-5
- LIN ET AL: "Carrier emission from the electronic states of self-assembled indium arsenide quantum dots" MATERIALS SCIENCE AND ENGINEERING C, ELSEVIER SCIENCE S.A, CH, Bd. 26, Nr. 5-7, 1. Juli 2006 (2006-07-01), Seiten 760-765, XP005461063 ISSN: 0928-4931
- GELLER M ET AL: "Tunneling emission from self-organized In(Ga)As/GaAs quantum dots observed via time-resolved capacitance measurements" PHYSICAL REVIEW B (CONDENSED MATTER AND MATERIALS PHYSICS) APS THROUGH AIP USA, Bd. 73, Nr. 20, 15. Mai 2006 (2006-05-15), Seiten 205331-1-20533-8, XP002480344 ISSN: 0163-1829
- BALOCCO C ET AL: "Room-temperature operations of memory devices based on self-assembled InAs quantum dot structures" APPLIED PHYSICS LETTERS, AIP, AMERICAN INSTITUTE OF PHYSICS, MELVILLE, NY, Bd. 85, Nr. 24, 1. Januar 1900 (1900-01-01), Seiten 5911-5913, XP012063807 ISSN: 0003-6951
- GELLER M ET AL: "Hole capture into self-organized InGaAs quantum dots" APPLIED PHYSICS LETTERS, AIP, AMERICAN INSTITUTE OF PHYSICS, MELVILLE, NY, Bd. 89, Nr. 23, 4. Dezember 2006 (2006-12-04), Seiten 232105-1-232105-3, XP012087453 ISSN: 0003-6951

## Beschreibung

Die Erfindung bezieht sich auf eine Speicherzelle mit den Merkmalen gemäß dem Oberbegriff des Patentanspruchs 1. Eine derartige Speicherzelle ist aus der Druckschrift: KOIKE K ET AL: "Charge storage effect of the vertically stacked InAs nanodots embedded in AlO.5Ga0.5As matrix" CONFERENCE PROCEEDINGS. 2001 INTERNATIONAL CONFERENCE ON INDIUM PHOSPHIDE AND RELATED MATERIALS.IPRM.NARA, JAPAN, MAY 14 - 18, 2001; [INTERNATIONAL CONFERENCE ON INDIUM PHOSPHIDE AND RELATED MATERIALS], NEW YORD, NY: IEEE, US, Bd. CONF. 13, 14. Mai 2001 (2001-05-14), Seiten 39-42, XP010546968 ISBN: 978-0-7803-6700-5 bekannt.

Die beiden heutzutage wichtigsten kommerziell erhältlichen Halbleiter-Speicherzellen sind DRAM- und Flash-Speicherzellen.

DRAM-Speicherzellen, die beispielsweise als Arbeitsspeicher in PCs zur Anwendung kommen, speichern die Information als Ladung in einem Kondensator (R. Waser, Microelectronics and Information Technology, Wiley-VCH, Berlin, 2003). Die Vorteile der DRAM-Speicherzellen liegen in einer schnellen Zugriffszeit im Bereich von unter 20 Nanosekunden und einer hohen Haltbarkeit von > 10¹⁵ Schreib- und Löschzyklen. Ein Nachteil der DRAM-Speicherzellen ist eine relativ kurze Speicherzeit von nur einigen zehn Millisekunden.

Bei Flash-Speicherzellen, die z. B. in Memory-Sticks, Digitalkameras oder Handys eingesetzt werden und gattungsgemäße Speicherzellen bilden, kommt eine MOSFET-Struktur mit einem zusätzlichen Floating-Gate als Speicherelement zum Einsatz (L. Geppert, The new indelible memories, IEEE Spectrum, 49-54 (2003); S. M. Sze, Evolution of Nonvolatile Semiconductor Memory: From Floating-Gate Concept to Single-Electron Memory Cell, in Future Trends in Microelectronics, edited by S. Luryi, J. Xu, and A. Zaslavsky, page 291, John Wiley & Sons, Inc., 1999).

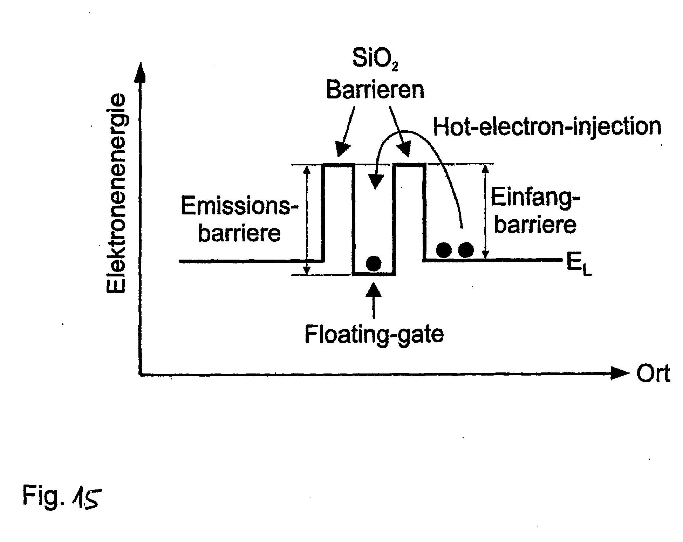

Den Bandverlauf einer vorbekannten Flash-Speicherzelle zeigt beispielhaft die Figur 15. Man erkennt SiO₂-Barrieren, die ein sogenanntes Floating-Gate einschließen, in dem Ladung gespeichert werden kann. Die SiO₂-Barrieren der Flash-Speicherzelle ermöglichen Speicherzeiten von >10 Jahren. Die SiO₂-Barrieren führen aber auch zu Nachteilen, nämlich zu einer langsamen Schreibzeit in der Größenordnung von Mikrosekunden und zu einer nur geringen Haltbarkeit von nur rund einer Million Lösch- und Schreibzyklen. Der Schreibprozess erfolgt in einer CHE-Flash-Zelle (CHE=channel hot electron) mittels einer Injektion heißer Ladungsträger (hot electron injection), bei der die Ladungsträger durch Anlegen einer Spannung so stark beschleunigt werden, dass sie über eine der beiden SiO₂-Barrieren in das Floating-Gate gebracht werden können. Die heißen Ladungsträger zerstören wegen ihrer hohen kinetischen Energie die Barriere, wodurch die Haltbarkeit begrenzt wird, und gelangen nur mit geringer Wahrscheinlichkeit in das Floating-Gate, wodurch der Schreibprozess sehr langsam ist.

Der Erfindung liegt demgemäß die Aufgabe zugrunde, eine Speicherzelle anzugeben, die sich relativ schnell beschreiben lässt und dennoch eine lange Speicherzeit aufweist.

Diese Aufgabe wird erfindungsgemäß durch eine Speicherzelle mit den Merkmalen des Anspruchs 1 und einem Verfahren zum Betreiben einer Speicherzelle nach Anspruch 14 gelöst. Vorteilhafte Ausgestaltungen der Erfindung sind in Unteransprüchen angegeben.

Danach ist erfindungsgemäß vorgesehen, dass die Speicherzelle eine Halbleiterstruktur mit einer Raumladungszone aufweist und der Potentialtopf durch eine Halbleiterheterostruktur gebildet ist, wobei die Halbleiterheterostruktur und die Raumladungszone relativ zueinander räumlich derart angeordnet sind, dass sich die Halbleiterheterostruktur bei Anliegen der Beibehaltespannung innerhalb der Raumladungszone, bei Anliegen der Einspeisespannung am Rand oder außerhalb der Raumladungszone und bei Anliegen der Entladespannung innerhalb der Raumladungszone befindet.

Ein wesentlicher Vorteil der erfindungsgemäßen Speicherzelle ist darin zu sehen, dass diese aufgrund der erfindungsgemäß vorgesehenen relativen Anordnung zwischen einer Raumladungszone und einer Halbleiterheterostruktur und damit aufgrund des Zusammenspiels zwischen Raumladungszone und Halbleiterheterostruktur sowohl schnell beschrieben werden kann als auch eine sehr lange Speicherzeit aufweist. Die Zugriffszeiten, also die Schreib- oder die Lesezeiten, liegen im Nanosekundenbereich, und gleichzeitig sind Speicherzeiten von mehreren Jahren möglich.

Die erfindungsgemäße Idee besteht darin, dass sich eine Halbleiterheterostruktur sehr schnell mit Ladungsträgern füllen und auch sehr schnell wieder von diesen befreien lässt, so dass die erwähnte hohe Zugriffsgeschwindigkeit erreicht wird.

Die lange Speicherzeit wird erfindungsgemäß dadurch erreicht, dass für den Speicherbetrieb, also für den Zustand des Beibehaltens der Speicherladung, die Raumladungszone auf die Halbleiterheterostruktur ausgeweitet wird, so dass die in der Halbleiterheterostruktur gefangenen Ladungsträger aus dieser nicht entweichen können; gleichzeitig können - und zwar aufgrund der Verarmung an Ladungsträgern innerhalb der Raumladungszone - auch keine anderen Ladungsträger in den Potentialtopf der Halbleiterheterostruktur hineinfallen, so dass der Beladungszustand des Potentialtopfes konserviert wird. Dadurch wird beispielsweise sowohl ein sicheres Speichern einer logischen Eins (zum Beispiel definiert durch einen gefüllten Potentialtopf) als auch ein sicheres Speichern einer logischen Null (zum Beispiel definiert durch einen leeren Potentialtopf) gewährleistet.

Mit anderen Worten besteht der erfinderische Gedanke also darin, eine Raumladungszone mit einer Halbleiterheterostruktur zu verknüpfen, um Bitinformationen zu speichern.

Vorzugsweise weist die Halbleiterheterostruktur mindestens eine Nanostruktur auf. Unter Nanostrukturen werden hier beispielsweise niederdimensionale Halbleiterstrukturen verstanden, deren Ausdehnung in eine oder mehrere Raumrichtungen so eingeschränkt ist, dass die Ausdehnung in dieser Raumrichtung in der Größenordnung der "de-Broglie"-Wellenlänge des betrachteten Ladungsträgers (Elektron oder Loch) liegt. Derartige Nanostrukturen können durch Quantenfilme, Quantendrähte oder Quantenpunkte gebildet sein, wie sie beispielsweise aus der Druckschrift "Quantum Dot Heterostructures" (D. Bimberg, M. Grundmann, and N. N. Ledentsov, John Wiley & Sons, Chichester, 1998) bekannt sind.

Die erlaubten Zustände der Nanostrukturen liegen vorzugsweise energetisch tiefer als die des sie umgebenden Materials (z. B. Matrixmaterial). Für die in einer solchen Nanostruktur gebundenen bzw. gespeicherten Ladungsträger liegt in diesem Falle eine Potentialbarriere vor, die die Ladungsträger nur durch eine Energieaufnahme überwinden können, um in das Leitungs- bzw. Valenzband des umgebenden Materials zu gelangen. Ein wesentlicher Vorteil der Nanostrukturen besteht darin, dass zur Darstellung eines Informationsbits nur relativ wenige Ladungsträger erforderlich sind, weil die Anzahl an verfügbaren Besetzungszuständen innerhalb des Potentialtopfes bei Nanostrukturen sehr klein ist: Im Idealfall kann ein Informationsbit mit nur einem oder zwei Ladungsträgern dargestellt werden. Speicherzellen mit Nanostrukturen unterscheiden sich damit erheblich von den eingangs beschriebenen vorbekannten Speicherzellentypen, bei denen zur Speicherung eines Informationsbits eine große Anzahl von Ladungsträgern benötigt wird und sich ein relativ hoher Energieverbrauch beim Schreib- und Löschprozess ergibt: Flash-Speicherzellen benötigen beispielsweise ca. eintausend Elektronen, während DRAM-Speicherzellen für ein Informationsbit sogar mehrere zehntausend Ladungsträger brauchen.

Vorzugsweise ist die Speicherzelle derart ausgestaltet, dass sich der Beladungszustand der Halbleiterheterostruktur durch Anlegen einer Durchlassspannung an die Anschlüsse vergrößern lässt und eine Vergrößerung des Beladungszustandes durch Relaxation der Ladungsträger von einer an die Halbleiterheterostruktur mittelbar oder unmittelbar angrenzenden Leitungs- oder Valenzbandkante eines dotierten Halbleitermaterials erfolgt, weil nämlich ein Relaxationsvorgang physikalisch sehr schnell abläuft.

Der Bandverlauf ist im Bereich der Halbleiterheterostruktur beispielsweise derart ausgebildet, dass der Beladungszustand der Halbleiterheterostruktur durch Anlegen einer Sperrspannung verringerbar ist und dass die Verringerung des Beladungszustandes kann beispielsweise auf einem Tunneleffekt beruhen.

Die Halbleiterstruktur kann beispielsweise aus einer III/V-Materialkombination, einer II/VI-Materialkombination oder aus einer IV/IV-Materialkombination bestehen.

Zum Auslesen der Speicherzelle kann beispielsweise eine ein 2-dimensionales Elektronengas enthaltende Ausleseschicht vorhanden sein. Vorzugsweise ist eine solche Ausleseschicht von der Halbleiterheterostruktur durch eine Halbleiterzwischenschicht getrennt. Die Dicke der Halbleiterzwischenschicht ist beispielsweise derart bemessen, dass die Ausleseschicht im Speicherzustand am Rand oder außerhalb der Raumladungszone liegt und die Dicke der Halbleiterzwischenschicht beträgt mindestens 5 nm.

Besonders bevorzugt ist die Halbleiterheterostruktur durch eine Trägerschicht gebildet, in der eine Mehrzahl a Nanostrukturen beabstandet voneinander angeordnet ist und dass das Schichtmaterial der Trägerschicht einen höheren elektrischen Widerstand aufweist als die Ausleseschicht. Dadurch, dass die Nanostrukturen beabstandet voneinander angeordnet sind, ist es möglich, Anschlusskontakte zum elektrischen Kontaktieren der Ausleseschicht ohne weitere Isolationsschichten durch die Halbleiterheterostruktur hindurchzuführen, ohne dass es zu einem unmittelbaren Kurzschluss zwischen den Nanostrukturen kommen kann.

Im Hinblick auf eine besonders große Informationsdichte wird es als vorteilhaft angesehen, wenn die Halbleiterheterostruktur eine Mehrzahl an Besetzungszuständen aufweist, die jeweils eine Bitinformation repräsentieren und von Ladungsträgern besetzt werden können, und dass die Anzahl der besetzten Besetzungszustände auslesbar ist. In dieser Weise lassen sich Ladungsträgermultiplexing und damit Multi-Level-Zellen realisieren.

Mit der Speicherzelle kann beispielsweise eine Auswerteeinrichtung in Verbindung stehen, die den Beladungszustand des zumindest einem Potentialtopfes misst und mit dem Messwert eine die Bitinformation angebende Zahl ermittelt.

Beispielsweise kann die Auswerteeinrichtung als Bitinformation eine binäre Zahl ausgeben.

Die Erfindung bezieht sich außerdem auf ein Verfahren zum Betreiben einer Speicherzelle, bei dem eine Bitinformation der Speicherzelle durch den Beladungszustand mindestens eines Potentialtopfes der Speicherzelle festgelegt wird, wobei durch Anlegen einer elektrischen Einspeisespannung an die Speicherzelle der Beladungszustand des Potentialtopfes mit Ladungsträgern vergrößert und durch Anlegen einer Entladespannung verkleinert wird und wobei bei Anlegen einer Beibehaltespannung die Ladungsträger innerhalb des Potentialtopfes gefangen bleiben. Ein solches Verfahren ist von den eingangs erwähnten Flash-Speicherzellen her bekannt.

Im Hinblick auf eine schnelle Zugriffszeit und eine lange Speicherzeit wird erfindungsgemäß vorgeschlagen, dass zum Vergrößern des Beladungszustandes eine derartige Einspeisespannung an die Speicherzelle angelegt wird, dass sich eine den Potentialtopf bildende Halbleiterheterostruktur am Rand oder außerhalb einer Raumladunsgzone der Speicherzelle befindet, dass zum Beibehalten des Beladungszustandes eine derartige Beibehaltespannung an die Speicherzelle angelegt wird, dass sich die Halbleiterheterostruktur innerhalb dieser Raumladungszone befindet und die Ladungsträger innerhalb der Halbleiterheterostruktur gefangen sind, und dass zum Verkleinern des Beladungszustandes eine derartige Entladespannung an die Speicherzelle angelegt wird, dass sich die Halbleiterheterostruktur innerhalb dieser Raumladungszone befindet, jedoch die Ladungsträger die Heterostruktur verlassen können.

Bezüglich der Vorteile des erfindungsgemäßen Verfahrens sei auf die obigen Ausführungen im Zusammenhang mit der erfindungsgemäßen Speicherzelle verwiesen, weil die Vorteile der erfindungsgemäßen Speicherzelle denen des erfindungsgemäßen Verfahrens im Wesentlichen entsprechen. Entsprechendes gilt für vorteilhafte Weiterbildungen des erfindungsgemäßen Verfahrens.

Das Auslesen kann beispielsweise durchgeführt werden, indem ein vom Beladungszustand des Potentialtopfes abhängiger elektrischer Widerstand einer ein 2-dimensionales Elektronengas enthaltenden Ausleseschicht ausgewertet wird und zum

Vergrößern des Beladungszustandes des Potentialtopfes wird bevorzugt eine derartige Einspeisespannung an die Speicherzelle angelegt, dass die Ladungsträger von einer an den Potentialtopf mittelbar oder unmittelbar angrenzenden Leitungs oder Valenzbandkante eines dotierten Halbleitermaterials in den Potentialtopf relaxieren und zum

Verringern des Beladungszustandes des Potentialtopfes wird eine derartige Entladespannung an die Speicherzelle angelegt, dass die Ladungsträger aus dem Potentialtopf heraustunneln.

Die Erfindung wird nachfolgend anhand von Ausführungsbeispielen näher erläutert; dabei zeigen beispielhaft
- Figuren 1-2: ein erstes Ausführungsbeispiel für eine er- findungsgemäße Speicherzelle mit einer Na- nostruktur (beispielsweise einem Quanten- film), die einen Potentialtopf bildet, oder mehrere Nanostrukturen (beispielsweise Quantenpunkte) die mehrere Potentialtöpfe bilden, sowie mit einer Ausleseschicht,
- Figuren 3-5: den Bandverlauf innerhalb der Speicherzelle gemäß der Figur 1 beim Beibehalten des Be- füllungszustandes des Potentialtopfes, beim Befüllen des Potentialtopfes und beim Ent- leeren des Potentialtopfes,
- Figur 6: den Einfluss der Ausleseschicht auf den Bandverlauf,
- Figur 7: ein zweites Ausführungsbeispiel für eine erfindungsgemäße Speicherzelle mit Na- nostrukturen, jedoch ohne Ausleseschicht,
- Figuren 8-9: ein drittes Ausführungsbeispiel für eine erfindungsgemäße Speicherzelle ohne Ausle- seschicht, jedoch mit einer zusätzlichen Hilfsschicht für ein verbessertes Tunnel- verhalten beim Entleeren des Potentialtop- fes;
- Figuren 10-11: ein viertes Ausführungsbeispiel für eine erfindungsgemäße Speicherzelle mit einer zusätzlichen Quantenfilmschicht für ein verbessertes Tunnelverhalten beim Entleeren des Potentialtopfes,
- Figuren 12-13: ein fünftes Ausführungsbeispiel für eine Speicherzelle 10 mit einer zusätzlichen deltaförmig dotierten Schicht,
- Figur 14: ein sechstes Ausführungsbeispiel mit einem gegenüber den Ausführungsbeispielen 1-5 in- versen Dotierungsprofil und
- Figur 15: zur allgemeinen Erläuterung eine Flash- Speicherzelle nach dem Stand der Technik.

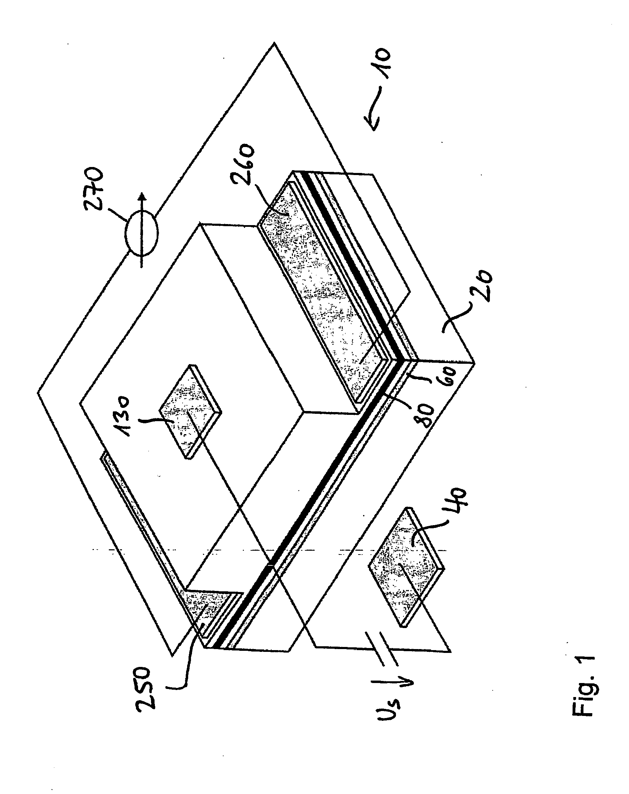

In den Figuren 1-14 werden für identische oder vergleichbare Komponenten der Übersicht halber dieselben Bezugszeichen verwendet.

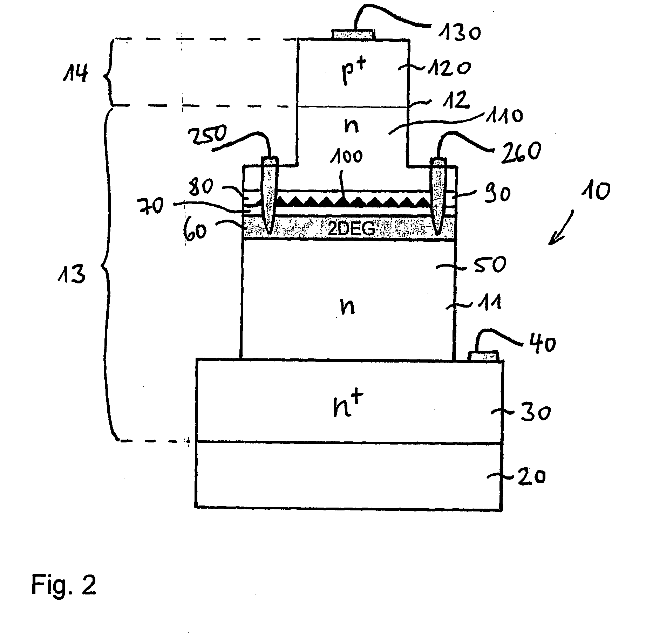

In der Figur 1 ist ein erstes Ausführungsbeispiel für eine Speicherzelle 10 in einer dreidimensionalen Sicht von schräg oben dargestellt. Die Figur 2 zeigt die entsprechende Speicherzelle 10 im Querschnitt.

Die Speicherzelle 10 enthält, wie weiter unten im Detail erläutert werden wird, eine Halbleiterstruktur 11 mit einem pn-Übergang 12, der eine Raumladungszone bereitstellt. Bei dem nachfolgend beschriebenen Ausführungsbeispiel wird davon ausgegangen, dass die den pn-Übergang 12 bildenden Schichten so angeordnet sind, dass n-dotiertes Speicherzellenmaterial 13 unterhalb des p-dotierten Speicherzellenmaterials 14 liegt; selbstverständlich ist diese Anordnung nur beispielhaft zu verstehen: So kann das n-dotierte Speicherzellenmaterial 13 stattdessen auch oberhalb des p-dotierten Speicherzellenmaterials 14 angeordnet werden.

Man erkennt in den beiden Figuren 1 und 2 ein Substrat 20, auf dem eine hoch n-dotierte Anschlussschicht 30 aufgebracht ist. Auf der Anschlussschicht 30 befindet sich ein unterer elektrischer Anschluss 40 der Speicherzelle 10. Das Substrat 20 besteht beispielsweise aus undotiertem GaAs und die hoch n-dotierte Anschlussschicht 30 aus AlₓGa₁₋ₓAs.

Auf der Anschlussschicht 30 liegt eine n-dotierte Zuleitungsschicht 50 auf, oberhalb derer eine Ausleseschicht 60 angeordnet ist; die Ausleseschicht 60 besteht beispielsweise aus InₓGa₁₋ₓAs und stellt ein 2-dimensionales Elektronengas zur Verfügung, das in der Figur 2 durch das Bezugszeichen 2DEG gekennzeichnet ist. Die n-dotierte Zuleitungsschicht 50 besteht beispielsweise aus AlₓGa₁₋ₓAs .

Durch eine Halbleiterzwischenschicht 70 beispielsweise aus demselben Material wie die Zuleitungsschicht 50 von der Ausleseschicht 60 getrennt ist eine Halbleiterheterostruktur 80 vorgesehen, die durch eine Trägerschicht 90 mit darin eingebetteten Nanostrukturen 100, beispielsweise in Form von Quantenpunkten, gebildet ist. Der Bandabstand der Halbleiterheterostruktur 80 ist kleiner als der in der darunter liegenden Schicht 70 sowie ebenfalls kleiner als in einer darüber befindlichen n-dotierten Abstandsschicht 110, so dass die Halbleiterheterostruktur 80 mindestens einen Potentialtopf bereitstellt, in dem Ladungsträger gefangen werden können.

Die Trägerschicht 90 besteht beispielsweise aus dotiertem oder undotiertem AlₓGa₁₋ₓAs, und die Nanostrukturen werden vorzugsweise aus InₓGa₁₋ₓSb oder InₓGa₁₋ₓAs gebildet. Die n-dotierte Abstandsschicht 110 kann beispielsweise aus demselben Material wie die n-dotierte Zuleitungsschicht 50 bestehen.

Auf der n-dotierten Abstandsschicht 110 befindet sich eine hoch p-dotierte Anschlussschicht 120 beispielsweise aus demselben Material wie die Abstandsschicht 110, auf der ein oberer elektrischer Anschluss 130 der Speicherzelle 10 aufliegt.

Durch die Übergangsstelle zwischen der hoch p-dotierten Anschlussschicht 120 und der n-dotierten Abstandsschicht 110 wird der pn-Übergang 12 gebildet. Durch den pn-Übergang 12 wird in der Speicherzelle 10 eine Raumladungszone hervorgerufen, deren Raumladungszonenweite von der an die beiden elektrischen Anschlüsse 40 und 130 angelegten Steuerspannung Us und der Dotierkonzentration in der Schicht 110 und 50 abhängt.

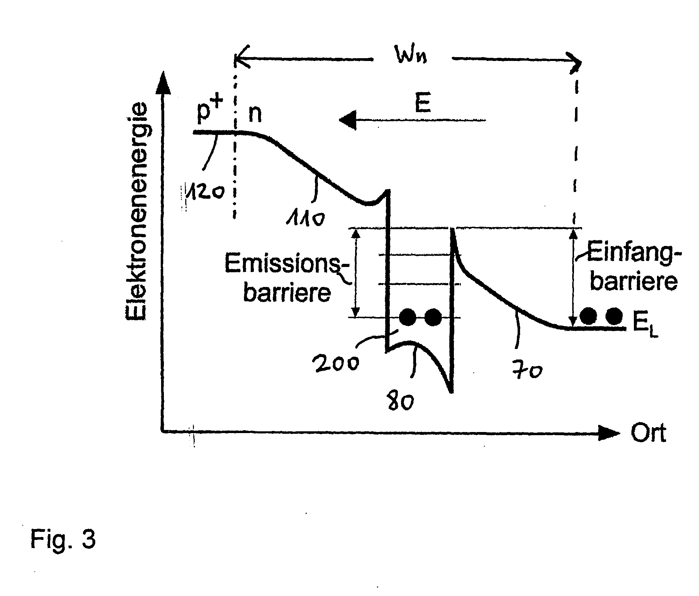

Die Figur 3 zeigt den Bandverlauf in der Speicherzelle 10 für den Fall, dass als Steuerspannung Us keine Spannung oder eine Beibehaltespannung angelegt wird, bei der der Beladungszustand der Speicherzelle 10 beibehalten bzw. konstant gehalten wird. Aus Gründen der Übersicht sind in der Figur 3 nur das Leitungsband E_{L} und Elektronen als Ladungsträger dargestellt; die nachstehenden Erläuterungen gelten aber für das Valenzband und für Löcher als Ladungsträger je nach der Ausführung der Halbleiterstruktur 11 entsprechend.

Es lässt sich in der Figur 3 erkennen, dass die Dotierung der Schichten der Speicherzelle 10 sowie die Dicke der Abstandsschicht 110 so gewählt sind, dass sich die Raumladungszone bei Anliegen der Beibehaltespannung (also beispielsweise bei Us = Ubei = 0V) bis in die Halbleiterheterostruktur 80 erstreckt und diese einschließt; die Raumladungszonenweite Wn innerhalb des n-dotiertes Speicherzellenmaterials 13 ist also größer, zumindest genauso groß, wie die Dicke des Schichtpakets, das sich aus der Abstandsschicht 110 und der Dicke der Halbleiterheteroschicht 80 zusammensetzt.

In der Figur 3 ist darüber hinaus erkennbar, dass die Ladungsträger, die sich innerhalb des durch die Halbleiterheterostruktur 80 gebildeten Potentialtopfes 200 befinden, diesen nicht verlassen können, weil sie die Emissionsbarriere nicht überwinden können. In diesem Zusammenhang sei erwähnt, dass die Höhe der Emissionsbarriere maßgeblich die Speicherzeit der Speicherzelle 10 bestimmt und daher möglichst groß sein sollte; vorzugsweise beträgt sie mindestens 1,0 eV um eine Speicherzeit von mehreren Tagen zu realisieren.

Aufgrund der räumlichen Lage des Potentialtopfes 200 innerhalb der Raumladungszone Wn wird außerdem sichergestellt, dass keine zusätzlichen Ladungsträger unerwünscht in den Potentialtopf 200 hineinfallen können und den Speicherzustand in dieser Weise verändern bzw. überschreiben können; denn die Raumladungszone ist sehr arm an freien Ladungsträgern, so dass schlicht keine Ladungsträger für eine Verfälschung des Speicherinhalts zur Verfügung stehen. Von außerhalb der Raumladungszone Wn können ebenfalls keine Ladungsträger in den Potentialtopfs 200 eindringen, weil sie die Einfangbarriere, die durch den Bandverlauf innerhalb der Raumladungszone gebildet wird, nicht überwinden können.

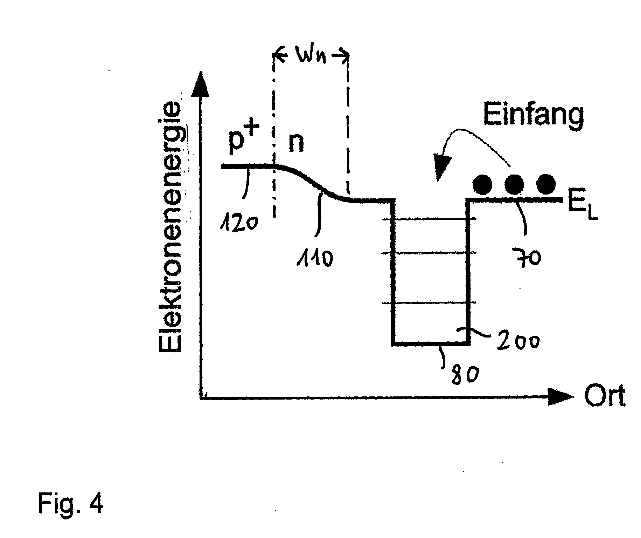

In der Figur 4 ist dargestellt, wie der Potentialtopf 200 mit Ladungsträgern gefüllt werden kann, um beispielsweise eine logische "Eins" in die Speicherzelle 10 einzuschreiben. Nachfolgend wird beispielhaft davon ausgegangen, dass eine logische Eins durch einen gefüllten Potentialtopf 200 und eine logische "Null" durch einen leeren Potentialtopf charakterisiert wird; selbstverständlich ist diese Festlegung beliebig und könnte auch umgekehrt sein.

Zum "Schreiben" einer logischen Eins wird an die beiden Anschlüsse 40 und 130 und damit an den pn-Übergang 12 als Steuerspannung Us eine Einspeisespannung Uspeis, und zwar eine Durchlassspannung Uspeis > Umin (Umin beträgt beispielsweise 0,7 V), angelegt, so dass die Raumladungszone Wn verkleinert wird. Man erkennt in der Figur 4, dass die Raumladungszonenweite Wn nicht mehr in die Halbleiterheterostruktur 80 hineinragt und die Einfangbarriere vollständig abgebaut ist. Somit können die Ladungsträger, im vorliegenden Fall Elektronen, von der Leitungsbandkante E_{L} in den Potentialtopf 200 im Rahmen eines Relaxationsprozesses unmittelbar "hineinfallen". Das Füllen des Potentialtopfes 200 erfolgt sehr schnell, so dass Schreibzeiten für das Schreiben des Zustands "mit Ladungsträgern gefüllt" (bzw. Bitinformation "Eins") in Pikosekunden möglich sind.

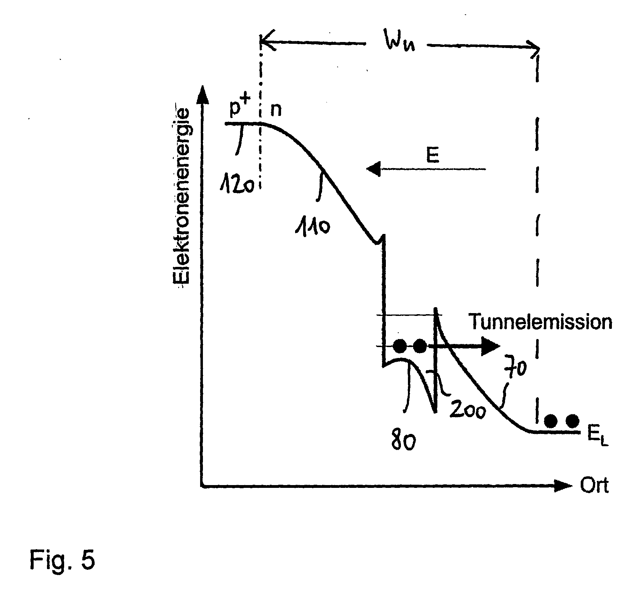

In der Figur 5 ist dargestellt, wie der Potentialtopf von den Ladungsträgern geleert werden kann, um beispielsweise eine logische "Null" in die Speicherzelle 10 einzuschreiben. Zum "Entleeren" (Schreiben einer logischen Null) wird an die beiden Anschlüsse 40 und 130 und damit an den pn-Übergang 12 als Entladespannung eine Sperrspannung Us = Usperr (Usperr beträgt beispielsweise -15 V) angelegt, so dass die Raumladungszone Wn vergrößert wird. Gleichzeitig wird der Bandverlauf verändert bzw. verzerrt, so dass eine Tunnelemission der in dem Potentialtopf 200 gefangenen Elektronen möglich wird. Die Elektronen können somit den Potentialtopf 200 verlassen, wodurch dieser geleert und die Speicherzelle mit einer logischen Null beschrieben wird.

Der Tunnelvorgang ist zwar etwas langsamer als der Relaxationsvorgang beim Befüllen des Potentialtopfes 200, jedoch sind dennoch Entleerungszeiten bzw. Schreibzeiten für eine logische Null im Nanosekundenbereich möglich.

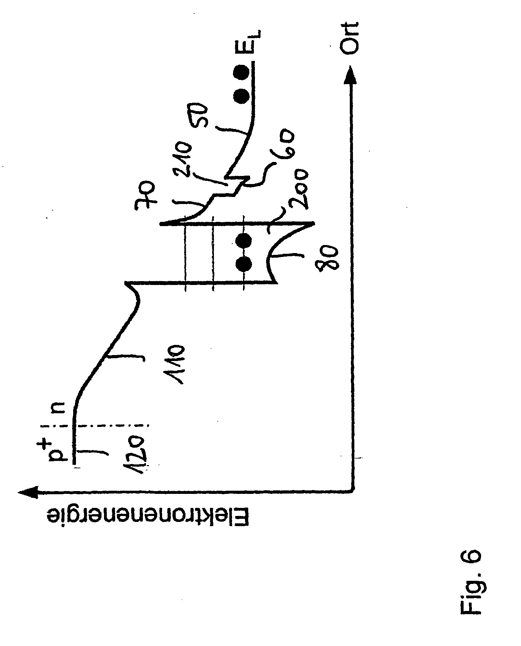

Im Zusammenhang mit den Figuren 1, 2 und 6 soll nun erläutert werden, wie die Speicherzelle 10 ausgelesen werden kann, ohne den Speicherzelleninhalt zu verändern. Hierzu wird die Ausleseschicht 60 herangezogen, deren Bandverlauf in der Figur 6 dargestellt ist. Man kann erkennen, dass der Bandabstand in der Ausleseschicht 60 geringer ist als in den benachbarten Schichten, also der Halbleiterzwischenschicht 70 und der n-dotierten Zuleitungsschicht 50, so das sich das bereits er wähnte 2-dimensionale Elektronengas in dem weiteren Potentialtopf 210 ausbilden kann.

Die Ausleseschicht 60 ist durch zwei seitliche Anschlusskontakte 250 und 260 (Fig. 1 und 2) kontaktiert, so dass die elektrischen Eigenschaften der Ausleseschicht 60 mit einem Messgerät 270 gemessen werden können. Aufgrund der Nähe der Ausleseschicht 60 zu der Halbleiterheterostruktur 80 sind die elektrischen Eigenschaften der Ausleseschicht 60 abhängig von dem Füllzustand bzw. der Beladung des Potentialtopfs 200 in der Halbleiterheterostruktur 80, so dass durch ein Messen der elektrischen Eigenschaften der Ausleseschicht 60 der Befüllungszustand des Potentialtopfs 200 gemessen und der Speicherzustand der Speicherzelle 10 bestimmt werden kann, ohne dass die Gefahr besteht, dadurch den Speicherzustand der Speicherzelle 10 zu verändern.

Beispielsweise kann der Beladungszustand des Potentialtopfs 200 bestimmt werden, indem der von diesem abhängige elektrische Widerstand der Ausleseschicht 60 gemessen und ausgewertet wird.

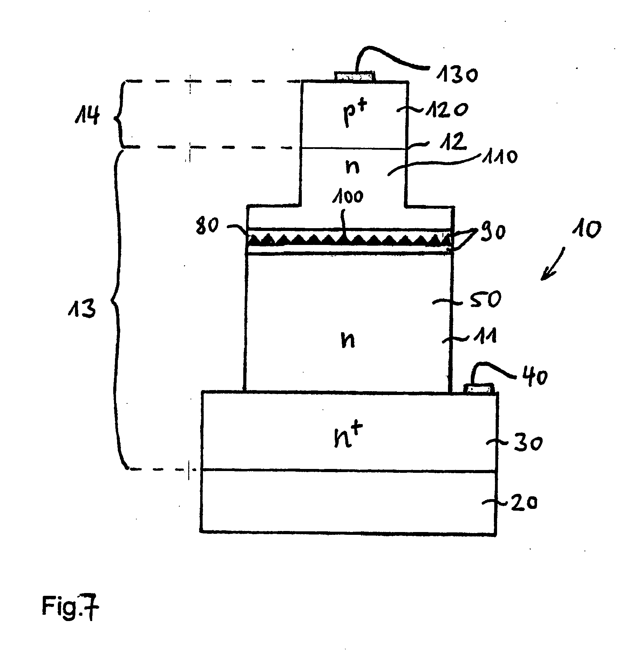

Die Figur 7 zeigt ein zweites Ausführungsbeispiel für eine Speicherzelle 10. Im Unterschied zu dem Ausführungsbeispiel gemäß den Figuren 1 bis 6 fehlen die Halbleiterzwischenschicht 70 und die Ausleseschicht 60, so dass die Halbleiterheterostruktur 80 unmittelbar an die n-dotierte Zuleitungsschicht 50 angrenzt.

Während das Schreiben von logischen Einsen und Nullen genauso ablaufen kann, wie dies im Zusammenhang mit den Figuren 1 bis 6 erläutert wurde, muss jedoch der Ausleseprozess anders durchgeführt werden, weil die Ausleseschicht 60 fehlt.

Beispielsweise wird das Auslesen durchgeführt, indem die vom Beladungszustand des Potentialtopfes abhängige Kapazität der -Raumladungszone Wn der Speicherzelle 10 ausgewertet wird. Alternativ kann das Auslesen durchgeführt werden, indem der vom Beladungszustand des Potentialtopfes abhängige elektrische Widerstand der Speicherzelle 10 ausgewertet wird.

Auch kann das Auslesen durchgeführt werden, indem der vom Beladungszustand des Potentialtopfes 200 abhängige Ladungstransfer von oder zu der Speicherzelle 10 ausgewertet wird. Das letztgenannte Verfahren kann sowohl durchgeführt werden, wenn die zum Schreiben einer Null bzw. zum Entladen vorgesehene Entladespannung anliegt, als auch dann, wenn die Beibehaltespannung an der Speicherzelle anliegt.

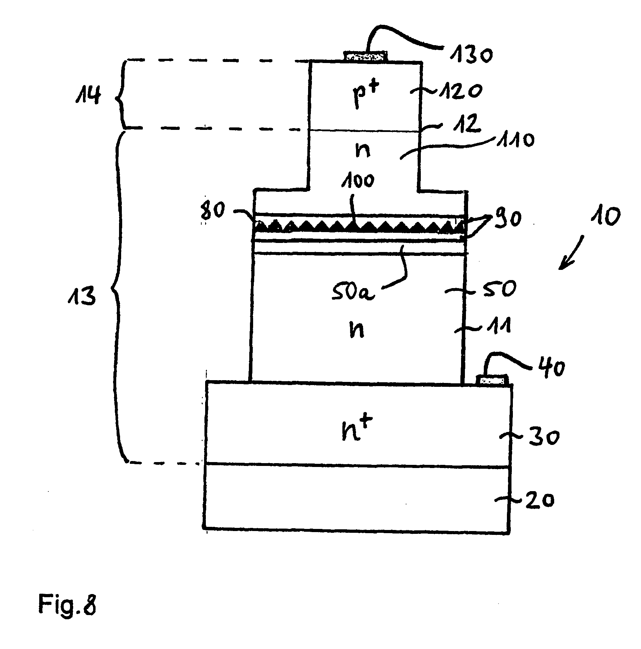

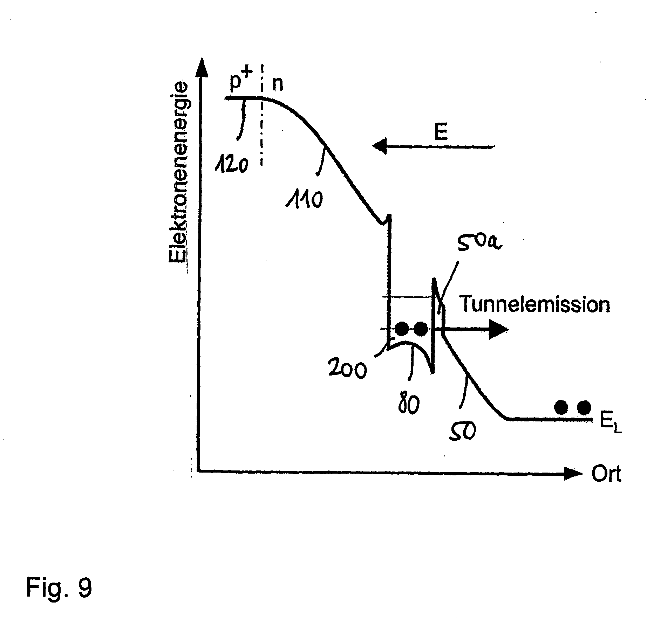

Die Figuren 8 und 9 zeigen ein drittes Ausführungsbeispiel für eine Speicherzelle 10. Bei diesem Ausführungsbeispiel ist - verglichen mit dem zweiten Ausführungsbeispiel gemäß der Figur 7 - zusätzlich eine Hilfsschicht 50a vorhanden, die die n-dotierte Zuleitungsschicht 50 von der Halbleiterheterostruktur 80 trennt. Die n-dotierte Zuleitungsschicht 50 weist einen kleineren Bandabstand als die Hilfsschicht 50a auf, so dass ein "Heraustunneln" der Ladungsträger aus dem Potentialtopf 200 beim Entleeren der Halbleiterheterostruktur 80 vereinfacht und damit beschleunigt wird. Das Schreiben einer "Null" ist aufgrund der Hilfsschicht 50a also schneller möglich als ohne diese Schicht. Die zugehörige Bandstruktur zeigt die Figur 9.

Die Schichten 50a und 110 können beispielsweise aus demselben Material bestehen, beispielsweise aus AlAs; die Schicht 50 besteht beispielsweise aus 50-prozentigem Al_{0.5}Ga_{0.5}As. Die resultierende energetische Höhe der Emissionsbarriere zwischen der Halbleiterheterostruktur 80 (z.B. aus GaSb oder InSb) und der AlAs-Barriere 50a würde in diesem Fall beispielsweise bei ungefähr 1 eV oder 1,2 eV liegen, wodurch sich eine Speicherzeit von Tagen bzw. Jahren bei Raumtemperatur ergibt. Aufgrund dieser Schichtanordnung ergibt sich zusätzlich auch eine Einfang Barriere beim Schreibprozess, die energetisch aber bei weitem nicht so hoch wie einem Flash-Speicher nach dem Stand der Technik ist.

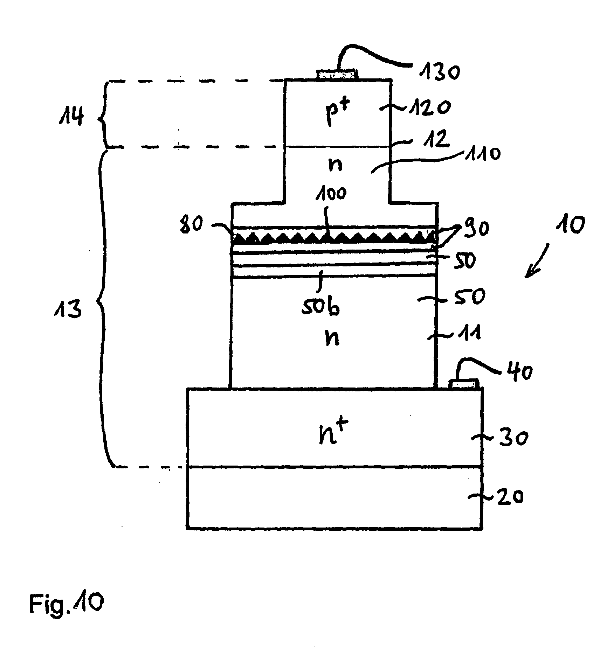

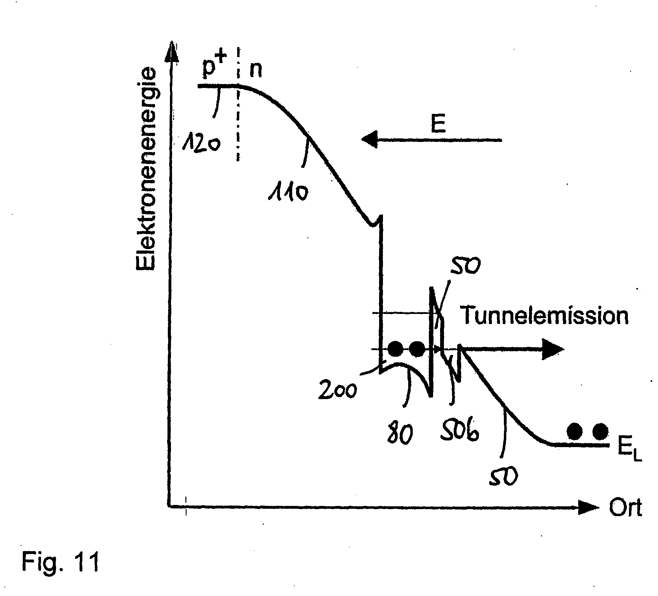

Die Figuren 10 und 11 zeigen ein viertes Ausführungsbeispiel für eine Speicherzelle 10. Bei diesem Ausführungsbeispiel ist - verglichen mit dem zweiten Ausführungsbeispiel gemäß der Figur 7 - zusätzlich eine Quantenfilmschicht 50b vorhanden, die innerhalb der n-dotierten Zuleitungsschicht 50 eingebettet ist. Die Quantenfilmschicht 50b weist einen kleineren Bandabstand als die n-dotierte Zuleitungsschicht 50 auf. Bei der Quantenfilmschicht 50b kann es sich beispielsweise um InₓGa₁₋ₓAs handeln, das in einer Zuleitungsschicht 50 aus AlₓGa₁₋ₓAs-Matrixmaterial eingebettet ist. Die Schichtdicke beträgt beispielsweise ca. 1 - 5nm; sie ermöglicht eine Erhöhung der Löschgeschwindigkeit, da sich innerhalb der Quantenfilmschicht 50b diskrete Energieniveaus ausbilden, die bei entsprechender Entladespannung ein resonantes Tunneln aus der Halbleiterheterostruktur 80 ermöglichen. Dies bedeutet, dass die Ladungsträger über die Zustände in der Quantenfilmschicht 50b einfacher ins Leitungs- oder Valenzband der Zuleitungsschicht 50 tunneln können als ohne diese Schicht.

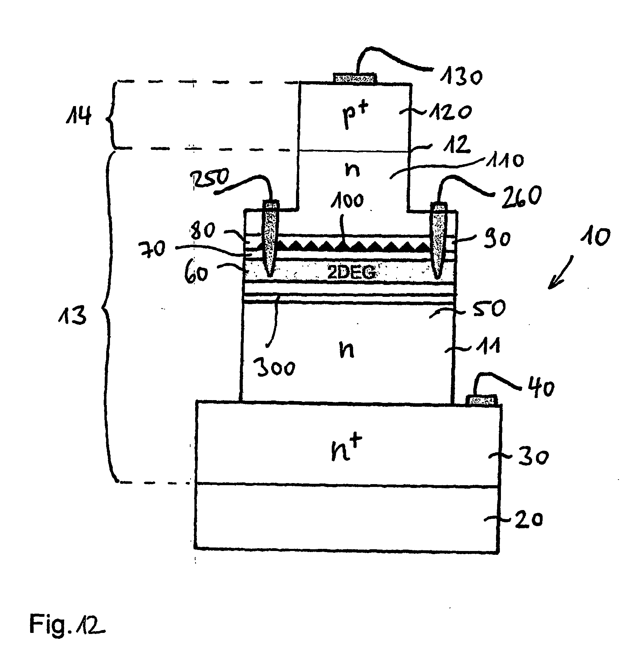

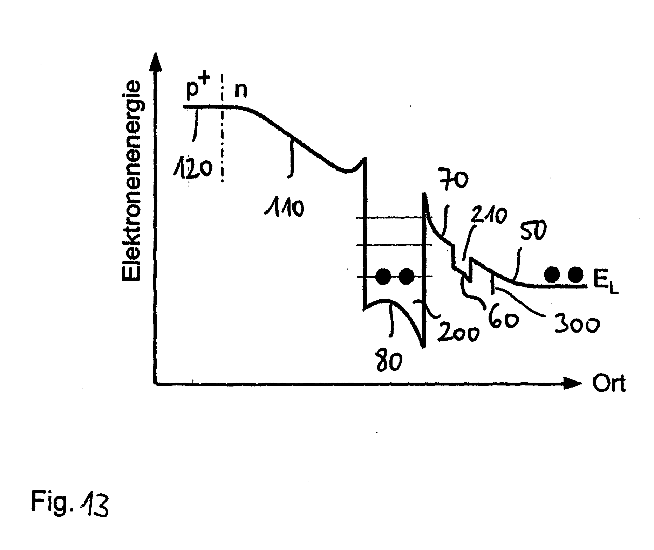

Die Figuren 12 und 13 zeigen ein fünftes Ausführungsbeispiel für eine Speicherzelle 10. Im Unterschied zu dem Ausführungsbeispiel gemäß den Figuren 1 bis 11 ist eine zusätzliche deltaförmig dotierte Schicht 300 vorhanden, die innerhalb der n-dotierten Zuleitungsschicht 50 angeordnet ist und eine höhere Dotierung wie die Zuleitungsschicht 50 aufweist. Die Dicke der deltaförmig dotierten Schicht 300 ist vorzugsweise eine Monolage. Die Funktion der deltaförmig dotierten Schicht 300 besteht darin, zusätzlich zur Zuleitungsschicht 50 Ladungsträger für die Ausbildung des zweidimensionalen Elektronengases 2DEG in der Ausleseschicht 60 zur Verfügung zu stellen.

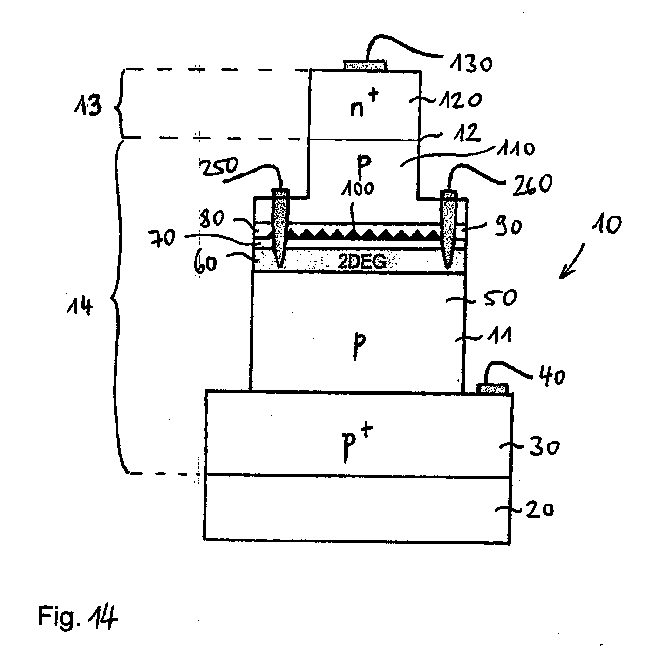

Die Figur 14 zeigt ein sechstes Ausführungsbeispiel für eine Speicherzelle 10. Im Unterschied zu den Ausführungsbeispielen gemäß den Figuren 1 bis 13 sind bei diesem fünften Ausführungsbeispiel die Schichten so angeordnet, dass n-dotiertes Speicherzellenmaterial 13 oberhalb des p-dotierten Speicherzellenmaterials 14 liegt.

Zusammenfassend sei erwähnt, dass grundsätzlich alle Arten von Halbleitermaterialien bzw. Halbleiterstrukturen eingesetzt werden können, mit denen sich Halbleiterheterostrukturen mit Potentialtöpfen bilden lassen. Besonders geeignet sind jedoch folgende Materialkombinationen: Für eine Al_{0,43}Ga_{0,57}As Trägerschicht 90, eine n-dotierte Zuleitungsschicht 50, eine n-dotierte Abstandsschicht 110 und InAs als Material für die Nanostrukturen 100 ergeben sich eine Emissionsbarrierenhöhe von circa mindestens 0,7 eV und damit Speicherzeiten bei Raumtemperatur von mehreren Millisekunden.

Für eine AlAs Trägerschichtschicht 90,eine p-dotierte Zuleitungsschicht 50, eine p-dotierte Abstandsschicht 110 und InAs als Material für die Nanostrukturen 100 ergeben sich eine Emissionsbarrierenhöhe von mindestens 0,75 eV und damit Speicherzeiten von mehreren Millisekunden bei Raumtemperatur.

Für eine AlAs Trägerschicht 90, eine p-dotierte Zuleitungsschicht 50, eine p-dotierte Abstandsschicht 110 und GaSb als Material für die Nanostrukturen 100 ergeben sich eine Emissionsbarrierenhöhe von mindestens 1 eV und damit Speicherzeiten von mehreren Tagen bei Raumtemperatur.

Für eine AlAs Trägerschicht 90, eine p-dotierte Zuleitungsschicht 50, eine p-dotierte Abstandsschicht 110 und InSb als Material für die Nanostrukturen 100 ergeben sich eine Emissionsbarrierenhöhe von mindestens 1,2 eV und damit Speicherzeiten von mehreren Jahren bei Raumtemperatur.

Auch ist zu erwähnen, dass die Halbleiterheterostruktur 80 ein ist Mehrzahl an Besetzungszuständen aufweisen kann, wie dies in der Figur 3 durch parallele Linien innerhalb des Potentialtopfes 80 angedeutet ist. Jeder Besetzungszustand kann jeweils eine Bitinformation repräsentieren, indem er von Ladungsträgern besetzt wird oder davon frei bleibt. Dadurch ist es möglich, mit einer mit der Speicherzelle in Verbindung stehenden Auswerteeinrichtung den Beladungszustand des Potentialtopfes zu messen und mit dem jeweiligen Messwert die durch den Beladungszustand definierte Bitinformation beispielsweise in Form einer Zahl zu ermitteln.

### Bezugszeichenliste

- 10: Speicherzelle
- 11: Halbleiterstruktur
- 12: pn-Übergang
- 13: n-dotiertes Speicherzellenmaterial
- 14: p-dotiertes Speicherzellenmaterial
- 20: Substrat
- 30: hoch n-dotierte Anschlussschicht
- 40: unterer elektrischer Anschluss
- 50: n-dotierte Zuleitungsschicht
- 50a: Hilfsschicht
- 50b: Quantenfilmschicht
- 60: Ausleseschicht
- 70: Halbleiterzwischenschicht
- 80: Halbleiterheterostruktur
- 90: Trägerschicht
- 100: Nanostrukturen
- 110: n-dotierte Abstandsschicht
- 120: hoch p-dotierte Anschlussschicht
- 130: oberer elektrischer Anschluss
- 200: Potentialtopf
- 210: weiterer Potentialtopf
- 250, 260: seitliche Anschlusskontakte
- 300: deltaförmig dotierte Schicht

- US: Steuerspannung
- Wn: Raumladungszonenweite

## Patentansprüche

1. Speicherzelle (10) zum Speichern mindestens einer Bitinformation, wobei die Speicherzelle eine Halbleiterstruktur (11) mit einem zumindest einen Potentialtopf (200) aufweisenden Bandverlauf (E_{L}) und zumindest zwei elektrische Anschlüsse (40, 130) umfasst,
- wobei sich durch Anlegen einer elektrischen Einspeisespannung (Us=Uspeis) an die zwei Anschlüsse der Beladungszustand des Potentialtopfes mit Ladungsträgern vergrößern, durch Anlegen einer Entladespannung (Us= Usperr) verkleinern und durch Anlegen einer Beibehaltespannung (Us=Ubei) beibehalten lässt und
- wobei der jeweilige Beladungszustand des Potentialtopfes die Bitinformation der Speicherzelle festlegt,
- wobei die Halbleiterstruktur eine Raumladungszone (Wn) aufweist und
- wobei der Potentialtopf durch eine Halbleiterheterostruktur (80) gebildet ist,
**dadurch gekennzeichnet, dass**
- die Halbleiterheterostruktur und die Raumladungszone relativ zueinander räumlich derart angeordnet sind, dass sich die Halbleiterheterostruktur bei Anliegen der Beibehaltespannung innerhalb der Raumladungszone, bei Anliegen der Einspeisespannung am Rand oder außerhalb der Raumladungszone und bei Anliegen der Entladespannung innerhalb der Raumladungszone befindet.

2. Speicherzelle nach Anspruch 1, **dadurch gekennzeichnet, dass** die Halbleiterheterostruktur mindestens eine Nanostruktur (100) aufweist.

3. Speicherzelle nach Anspruch 1 oder 2, **dadurch gekennzeichnet,**
- **dass** der Beladungszustand der Halbleiterheterostruktur durch Anlegen einer Durchlassspannung an die Anschlüsse vergrößerbar ist und
- **dass** die Vergrößerung des Beladungszustandes durch Relaxation der Ladungsträger von einer an die Halbleiterheterostruktur mittelbar oder unmittelbar angrenzenden Leitungs- oder Valenzbandkante eines dotierten Halbleitermaterials erfolgt.

4. Speicherzelle nach einem der voranstehenden Ansprüche, **dadurch gekennzeichnet,**
- **dass** der Bandverlauf im Bereich der Halbleiterheterostruktur derart ausgebildet ist, dass der Beladungszustand der Halbleiterheterostruktur durch Anlegen einer Sperrspannung an die Anschlüsse verringerbar ist, und
- **dass** die Verringerung des Beladungszustandes auf einem Tunneleffekt beruht, durch den die Ladungsträger die Halbleiterheterostruktur verlassen.

5. Speicherzelle nach einem der voranstehenden Ansprüche, **dadurch gekennzeichnet, dass** die Halbleiterstruktur aus einer III/V-Materialkombination, einer II/VI-Materialkombination oder aus einer IV/IV-Materialkombination besteht.

6. Speicherzelle nach einem der voranstehenden Ansprüche, **dadurch gekennzeichnet, dass** eine ein 2-dimensionales Elektronengas (2DEG) enthaltende Ausleseschicht (60) vorhanden ist, die ein Auslesen der Bitinformation der Speicherzelle ermöglicht.

7. Speicherzelle nach Anspruch 6, **dadurch gekennzeichnet, dass** die Ausleseschicht von der Halbleiterheterostruktur durch eine Halbleiterzwischenschicht (70) getrennt ist.

8. Speicherzelle nach Anspruch 7, **dadurch gekennzeichnet,**
- **dass** die Dicke der Halbleiterzwischenschicht derart bemessen ist, dass die Ausleseschicht im Speicherzustand am Rand oder außerhalb der Raumladungszone liegt, und
- **dass** die Dicke der Halbleiterzwischenschicht mindestens 5 nm beträgt.

9. Speicherzelle nach einem der voranstehenden Ansprüche, **dadurch gekennzeichnet,**
- **dass** die Halbleiterheterostruktur durch eine Trägerschicht (90) gebildet ist, in der eine Mehrzahl an Nanostrukturen (100) beabstandet voneinander angeordnet ist, und
- **dass** das Schichtmaterial der Trägerschicht einen höheren elektrischen Widerstand aufweist als die Ausleseschicht.

10. Speicherzelle nach Anspruch 9, **dadurch gekennzeichnet, dass** Anschlusskontakte (250, 260) zum elektrischen Kontaktieren der Ausleseschicht durch die Halbleiterheterostruktur hindurchgeführt sind.

11. Speicherzelle nach einem der voranstehenden Ansprüche, **dadurch gekennzeichnet, dass** die Halbleiterheterostruktur eine Mehrzahl an Besetzungszuständen aufweist, die jeweils eine Bitinformation repräsentieren, indem sie von Ladungsträgern besetzt werden können, und dass die Anzahl der besetzten Besetzungszustände auslesbar ist.

12. Speichereinrichtung mit mindestens einer Speicherzelle nach einem der voranstehenden Ansprüche, **dadurch gekennzeichnet, dass** mit der Speicherzelle eine Auswerteeinrichtung in Verbindung steht, die den Beladungszustand des zumindest einen Potentialtopfes misst und mit dem Messwert eine die Bitinformation angebende Zahl ermittelt.

13. Speichereinrichtung nach Anspruch 12, **dadurch gekennzeichnet, dass** die Auswerteeinrichtung als Bitinformation eine binäre Zahl ausgibt.

14. Verfahren zum Betreiben einer Speicherzelle (10), bei dem eine Bitinformation der Speicherzelle durch den Beladungszustand mindestens eines Potentialtopfes (200) der Speicherzelle festgelegt wird,
- wobei durch Anlegen einer elektrischen Einspeisespannung (Us=Uspeis) an die Speicherzelle der Beladungszustand des Potentialtopfe mit Ladungsträgern vergrößert und durch Anlegen einer Entladespannung (Us=Usperr) verkleinert wird und
- wobei bei Anlegen einer Beibehaltespannung (Us=Ubei) die Ladungsträger innerhalb des Potentialtopfes gefangen bleiben,
**dadurch gekennzeichnet,**
- **dass** zum Vergrößern des Beladungszustandes eine derartige Einspeisespannung an die Speicherzelle angelegt wird, dass sich eine den Potentialtopf bildende Halbleiterheterostruktur (80) am Rand oder außerhalb einer Raumladunsgzone (Wn) der Speicherzelle befindet,
- **dass** zum Beibehalten des Beladungszustandes eine derartige Beibehaltespannung an die Speicherzelle angelegt wird, dass sich die Halbleiterheterostruktur innerhalb dieser Raumladungszone befindet, und
- **dass** zum Verkleinern des Beladungszustandes eine derartige Entladespannung an die Speicherzelle angelegt wird, dass sich die Halbleiterheterostruktur innerhalb dieser Raumladungszone befindet, jedoch die Ladungsträger die Heterostruktur verlassen können.

15. Verfahren nach Anspruch 14, **dadurch gekennzeichnet,**
- **dass** das Auslesen durchgeführt wird, indem eine ein 2-dimensionales Elektronengas enthaltende Ausleseschicht ausgelesen wird, indem deren vom Beladungszustand des Potentialtopfes abhängiger elektrischer Widerstand ausgewertet wird,
- **dass** zum Vergrößern des Beladungszustandes des Pctentialtopfes eine derartige Einspeisespannung an die Speicherzelle angelegt wird, dass die Ladungsträger von einer an den Potentialtopf mittelbar oder unmittelbar angrenzenden Leitungs- oder Valenzbandkante eines dotierten Halbleitermaterials in den Potentialtopf relaxieren, und
- **dass** zum Verringern des Beladungszustandes des Potentialtopfes eine derartige Entladespannung an die Speicherzelle angelegt wird, dass die Ladungsträger aus dem Potentialtopfs heraustunneln.

## Claims

1. Memory cell (10) for storing at least one item of bit information, wherein the memory cell comprises a semiconductor structure (11) with a band profile (E_{L}) having at least one potential well (200) and comprises at least two electrical connections (40, 130),
- wherein the charged state of the potential well with charge carriers can be increased by applying an electrical supply voltage (Us=Usupply) to the two connections, can be reduced by applying a discharge voltage (Us=Urev), and can be maintained by applying a maintaining voltage (Us=Umaint), and
- wherein the respective charged state of the potential well defines the item of bit information of the memory cell,
- wherein the semiconductor structure has a space charge zone (Wn), and
- wherein the potential well is formed by a semiconductor heterostructure (80),
**characterized in that**
- the semiconductor heterostructure and the space charge zone are spatially arranged relative to one another in such a way that the semiconductor heterostructure is situated within the space charge zone when the maintaining voltage is present, at the edge of or outside the space charge zone when the supply voltage is present, and within the space charge zone when the discharge voltage is present.

2. Memory cell according to Claim 1, **characterized in that** the semiconductor heterostructure has at least one nanostructure (100).

3. Memory cell according to Claim 1 or 2, **characterized**
- **in that** the charged state of the semiconductor heterostructure can be increased by applying a forward voltage to the connections, and
- **in that** the charged state is increased by relaxation of the charge carriers from a conduction or valence band edge of a doped semiconductor material that is indirectly or directly adjacent to the semiconductor heterostructure.

4. Memory cell according to any of the preceding claims, **characterized**
- **in that** the band profile is embodied in the region of the semiconductor heterostructure in such a way that the charged state of the semiconductor heterostructure can be reduced by applying a reverse voltage to the connections, and
- **in that** the reduction of the charged state is based on a tunnel effect by means of which the charge carriers leave the semiconductor heterostructure.

5. Memory cell according to any of the preceding claims, **characterized in that** the semiconductor structure comprises a III/V material combination, a II/VI material combination or a IV/IV material combination.

6. Memory cell according to any of the preceding claims, **characterized in that** a read-out layer (60) containing a two-dimensional electron gas (2DEG) is present, which enables the item of bit information of the memory cell to be read out.

7. Memory cell according to Claim 6, **characterized in that** the read-out layer is separated from the semiconductor heterostructure by a semiconductor interlayer (70).

8. Memory cell according to Claim 7, **characterized**
- **in that** the thickness of the semiconductor interlayer is dimensioned in such a way that the read-out layer lies at the edge of or outside the space charge zone in the storage state, and
- **in that** the thickness of the semiconductor interlayer is at least 5 nm.

9. Memory cell according to any of the preceding claims, **characterized**
- **in that** the semiconductor heterostructure is formed by a carrier layer (90) in which a plurality of nanostructures (100) are arranged at a distance from one another, and
- **in that** the layer material of the carrier layer has a higher electrical resistance than the read-out layer.

10. Memory cell according to Claim 9, **characterized in that** connection contacts (250, 260) for making electrical contact with the read-out layer are led through the semiconductor heterostructure.

11. Memory cell according to any of the preceding claims, **characterized in that** the semiconductor heterostructure has a plurality of occupation states which each represent an item of bit information by virtue of the fact that they can be occupied by charge carriers, and **in that** the number of occupied occupation states can be read out.

12. Memory device having at least one memory cell according to any of the preceding claims, **characterized in that** an evaluation device is connected to the memory cell, which evaluation device measures the charged state of the at least one potential well and, with the measured value, determines a number indicating the item of bit information.

13. Memory device according to Claim 12, **characterized in that** the evaluation device outputs a binary number as bit information.

14. Method for operating a memory cell (10), in which an item of bit information of the memory cell is defined by the charged state of at least one potential well (200) of the memory cell,
- wherein the charged state of the potential well with charge carriers is increased by applying an electrical supply voltage (Us=Usupply) to the memory cell, and is reduced by applying a discharge voltage (Us=Urev), and
- wherein the charge carriers remain trapped within the potential well upon application of a maintaining voltage (Us=Umaint),
**characterized**
- **in that** for increasing the charged state, a supply voltage is applied to the memory cell which is such that a semiconductor heterostructure (80) forming the potential well is situated at the edge of or outside a space charge zone (Wn) of the memory cell,
- **in that**, for maintaining the charged state, a maintaining voltage is applied to the memory cell which is such that the semiconductor heterostructure is situated within said space charge zone, and
- **in that**, for reducing the charged state, a discharge voltage is applied to the memory cell which is such that the semiconductor heterostructure is situated within said space charge zone, but the charge carriers can leave the heterostructure.

15. Method according to Claim 14, **characterized**
- **in that** the read-out is carried out by reading a read-out layer containing a two-dimensional electron gas, by evaluating the electrical resistance of said read-out layer, said electrical resistance being dependent on the charged state of the potential well,
- **in that**, for increasing the charged state of the potential well, a supply voltage is applied to the memory cell which is such that the charge carriers relax into the potential well from a conduction or valence band edge of a doped semiconductor material that is indirectly or directly adjacent to the potential well, and
- **in that**, for reducing the charged state of the potential well, a discharge voltage is applied to the memory cell which is such that the charge carriers tunnel out of the potential well.

## Revendications

1. Cellule de mémoire (10) destinée à conserver au moins un bit d'information, la cellule de mémoire comportant une structure semi-conductrice (11) dotée d'une courbe de bande (E_{L}) qui présente au moins un puits de potentiel (200), et au moins deux bornes (40, 130) de raccordement électrique,
- dans laquelle l'état de charge en porteurs de charge du puits de potentiel augmente par application d'une tension électrique d'alimentation (Us = Uspeis) sur les deux bornes de raccordement, diminue par application d'une tension de décharge (Us = Usperr) et est maintenu par application d'une tension de maintien (Us = Ubei) et
- l'état particulier de charge du puits de potentiel représentant le bit d'information de la cellule de mémoire,
- la structure semi-conductrice présentant une zone (Wn) de charge spatiale et
- le puits de potentiel étant formé par une hétérostructure semi-conductrice (80),
**caractérisée en ce que**
- l'hétérostructure semi-conductrice et la zone de charge sont disposées spatialement l'une par rapport à l'autre de telle sorte que lors de l'application de la tension de maintien, l'hétérostructure semi-conductrice est située à l'intérieur de la zone de charge spatiale, que lors de l'application de la tension d'alimentation, elle est située sur le bord ou à l'extérieur de la zone de charge spatiale et que lors de l'application de la tension de décharge, elle est située à l'intérieur de la zone de charge spatiale.

2. Cellule de mémoire selon la revendication 1, **caractérisée en ce que** l'hétérostructure semi-conductrice présente au moins une nanostructure (100).

3. Cellule de mémoire selon la revendication 1 ou 2, **caractérisée en ce que** l'état de charge de l'hétérostructure semi-conductrice peut être augmenté par application d'une tension de passage sur les bornes de raccordement et **en ce que** l'augmentation de l'état de charge s'effectue par relaxation des porteurs de charge du bord, adjacent directement ou indirectement à l'hétérostructure semi-conductrice, d'une bande de conduction ou de valence d'un matériau semi-conducteur dopé.

4. Cellule de mémoire selon l'une des revendications précédentes, **caractérisée en ce qu'**au niveau de l'hétérostructure semi-conductrice, la courbe de bande est configurée de telle sorte que l'état de charge de l'hétérostructure semi-conductrice puisse diminuer par application d'une tension de blocage sur les bornes de raccordement et **en ce que** la diminution de l'état de charge repose sur un effet tunnel par lequel les porteurs de charge quittent l'hétérostructure semi-conductrice.

5. Cellule de mémoire selon l'une des revendications précédentes, **caractérisée en ce que** la structure semi-conductrice est constituée d'une combinaison de matériaux III/V, d'une combinaison de matériaux II/VI ou d'une combinaison de matériaux IV/IV.

6. Cellule de mémoire selon l'une des revendications précédentes, **caractérisée en ce qu'**elle présente une couche de lecture (60) qui contient un gaz bidimensionnel d'électrons (2DEG) qui permet la lecture du bit d'information de la cellule de mémoire.

7. Cellule de mémoire selon la revendication 6, **caractérisée en ce que** la couche de lecture est séparée de l'hétérostructure semi-conductrice par une couche semi-conductrice intermédiaire (70).

8. Cellule de mémoire selon la revendication 7, **caractérisée en ce que** l'épaisseur de la couche intermédiaire semi-conductrice est dimensionnée de telle sorte que la couche de lecture soit située à l'état de mémoire sur le bord ou à l'extérieur de la zone de charge spatiale et **en ce que** l'épaisseur de la couche intermédiaire semi-conductrice est d'au moins 5 mm.

9. Cellule de mémoire selon l'une des revendications précédentes, **caractérisée en ce que** l'hétérostructure semi-conductrice est formée par une couche de support (90) dans laquelle plusieurs nanostructures (100) sont disposées à distance les unes des autres et **en ce que** le matériau de la couche de support présente une résistance électrique plus élevée que la couche de lecture.

10. Cellule de mémoire selon la revendication 9, **caractérisée en ce que** des contacts de raccordement (250, 260) qui assurent le contact électrique de la couche de lecture traversent l'hétérostructure semi-conductrice.

11. Cellule de mémoire selon l'une des revendications précédentes, **caractérisée en ce que** l'hétérostructure semi-conductrice présente plusieurs états d'occupation qui représentent tous un bit d'information en pouvant être occupés par des porteurs de charge et **en ce que** les différents états occupés peuvent être lus.

12. Dispositif de mémoire qui présente au moins une cellule de mémoire selon l'une des revendications précédentes, **caractérisé en ce que** la cellule de mémoire communique avec un dispositif d'évaluation qui mesure l'état de charge du ou des puits de potentiel et qui détermine avec la valeur de mesure un nombre qui indique le bit d'information.

13. Dispositif de mémoire selon la revendication 12, **caractérisé en ce que** le dispositif d'évaluation délivre un nombre binaire comme bit d'information.

14. Procédé d'utilisation d'une cellule de mémoire (10) dans lequel un bit d'information de la cellule de mémoire est défini par l'état de charge d'au moins un puits de potentiel (200) de la cellule de mémoire,
- dans lequel l'état de charge en porteurs de charge du puits de potentiel est augmenté par application d'une tension électrique d'alimentation (Us = Uspeis) sur la cellule de mémoire, cet état de charge étant diminué par application d'une tension de décharge (Us = Usperr) et
- les porteurs de charge restent piégés à l'intérieur du puits de potentiel lors de l'application d'une tension de maintien (Us = Ubei),
**caractérisé en ce que**
- pour augmenter l'état de charge, on applique sur la cellule de mémoire une tension d'alimentation telle qu'une hétérostructure semi-conductrice (80) qui forme le puits de potentiel soit située sur le bord ou à l'extérieur d'une zone (Wn) de charge spatiale de la cellule de mémoire,
- **en ce que** pour maintenir l'état de charge, on applique sur la cellule de mémoire une tension de maintien telle que l'hétérostructure semi-conductrice soit située à l'intérieur de cette zone de charge spatiale et
- **en ce que** pour diminuer l'état de charge, on applique sur la cellule de mémoire une tension de décharge telle que l'hétérostructure semi-conductrice soit située à l'intérieur de cette zone de charge spatiale mais que les porteurs de charge puissent quitter l'hétérostructure.

15. Procédé selon la revendication 14, **caractérisé en ce que** la lecture est exécutée en lisant une couche de lecture qui contient un gaz bidimensionnel d'électrons en évaluant sa résistance électrique qui dépend de l'état de charge du puits de potentiel,
**en ce que** pour augmenter l'état de charge du puits de potentiel, on applique sur la cellule de mémoire une tension d'alimentation telle que les porteurs de charge se relaxent dans le puits de potentiel depuis un bord de bande de conduction ou de valence adjacent directement ou indirectement au puits de potentiel et
**en ce que** pour diminuer l'état de charge du puits de potentiel, on applique sur la cellule de mémoire une tension de décharge telle que les porteurs de charge sortent du puits de potentiel par effet tunnel.
